# EUROPEAN PATENT SPECIFICATION

(11) **EP 3 803 605 B1**
(45) Date of publication and mention of the grant of the patent: **07.10.2026**
(21) Application number: 19810601.5
(22) Date of filing: 24.04.2019
(51) Int. Cl.: G11C 16/34, G06F 3/06, G06F 12/02

(54) **DATA RELOCATION IN MEMORY HAVING TWO PORTIONS OF DATA**
DATENVERLAGERUNG IN EINEM SPEICHER MIT ZWEI DATENABSCHNITTEN
TRANSLATION DE DONNÉES DANS UNE MÉMOIRE COMPRENANT DEUX PARTIES DE DONNÉES

(30) Priority: 31.05.2018 US 201815994477
(43) Date of publication of application: 14.04.2021
(73) Proprietor: Micron Technology, Inc., Boise, ID 83707-0006 (US)
(72) Inventor: AMATO, Paolo, 24047 Treviglio (IT); BALLUCHI, Daniele, 20063 Cernusco Sul Naviglio (IT)
(74) Representative: Marks & Clerk LLP
(86) International application number: PCT/US2019/028854
(87) International publication number: WO 2019/231584

(56) References cited:
- EP-A1- 1 713 085
- EP-A1- 3 477 463
- US-A1- 2010 329 038
- US-A1- 2012 271 991
- US-A1- 2014 122 774
- US-A1- 2016 267 014
- US-A1- 2017 116 131
- US-B1- 9 710 180

## Description

### Technical Field

The present disclosure relates generally to semiconductor memory and methods, and more particularly, to data relocation in memory having two portions of data.

### Background

Memory devices are typically provided as internal, semiconductor, integrated circuits and/or external removable devices in computers or other electronic devices. There are many different types of memory including volatile and non-volatile memory. Volatile memory can require power to maintain its data and can include random-access memory (RAM), dynamic random access memory (DRAM), and synchronous dynamic random access memory (SDRAM), among others. Non-volatile memory can provide persistent data by retaining stored data when not powered and can include NAND flash memory, NOR flash memory, read only memory (ROM), and resistance variable memory such as phase change random access memory (PCRAM), resistive random access memory (RRAM), and magnetic random access memory (MRAM), among others.

Memory devices can be combined together to form a solid state drive (SSD), an embedded MultiMediaCard (e.MMC), and/or a universal flash storage (UFS) device. An SSD, e.MMC, and/or UFS device can include non-volatile memory (e.g., NAND flash memory and/or NOR flash memory), and/or can include volatile memory (e.g., DRAM and/or SDRAM), among various other types of non-volatile and volatile memory. Non-volatile memory may be used in a wide range of electronic applications such as personal computers, portable memory sticks, digital cameras, cellular telephones, portable music players such as MP3 players, movie players, among others.

Flash memory devices can include memory cells storing data in a charge storage structure such as a floating gate, for instance. Flash memory devices typically use a one-transistor memory cell that allows for high memory densities, high reliability, and low power consumption. Resistance variable memory devices can include resistive memory cells that can store data based on the resistance state of a storage element (e.g., a resistive memory element having a variable resistance).

Memory cells can be arranged into arrays, and memory cells in an array architecture can be programmed to a target (e.g., desired) state. For instance, electric charge can be placed on or removed from the charge storage structure (e.g., floating gate) of a flash memory cell to program the cell to a particular data state. The stored charge on the charge storage structure of the cell can indicate a threshold voltage (Vt) of the cell. A state of a flash memory cell can be determined by sensing the stored charge on the charge storage structure (e.g., the Vt) of the cell.

As an additional example, resistive memory cells can be programmed to store data corresponding to a target data state by varying the resistance level of the resistive memory element. Resistive memory cells can be programmed to a target data state (e.g., corresponding to a particular resistance state) by applying sources of an electrical field or energy, such as positive or negative electrical pulses (e.g., positive or negative voltage or current pulses) to the cells (e.g., to the resistive memory element of the cells) for a particular duration. A state of a resistive memory cell can be determined by sensing current through the cell responsive to an applied interrogation voltage. The sensed current, which varies based on the resistance level of the cell, can indicate the state of the cell.

A single level memory cell (SLC) can be programmed to a targeted one of two different data states, which can be represented by the binary units 1 or 0. Some flash and resistive memory cells can be programmed to a targeted one of more than two data states (e.g., 1111, 0111, 0011, 1011, 1001, 0001, 0101, 1101, 1100, 0100, 0000, 1000, 1010, 0010, 0110, and 1110). Such cells may be referred to as multi state memory cells, multiunit cells, or multilevel cells (MLCs). MLCs can provide higher density memories without increasing the number of memory cells since each cell can represent more than one digit (e.g., more than one bit).

EP 3477463 A1 discloses a data storage device includes a persistent storage and a processor. The persistent storage stores data. The processor obtains a data access request for the data stored in the persistent storage, obtains a portion of the data from the persistent storage using a global migration progress index, and provides the obtained portion of the data in response to the data access request.

US 2016/267014 A1 discloses a storage apparatus includes a physical memory including a plurality of first memory lines a part of which are assigned consecutive addresses and the rest of which are put into an unassigned state where no address is assigned and a second memory line assigned one of the consecutive addresses. The storage apparatus determines based on an address whether a write access to the physical memory is a write access to a first memory line or the second memory line, counts the numbers of times the first memory lines are written and the number of times the second memory line is written, and uses, when the total sum of the counted numbers of times exceeds a threshold, a first memory line in the unassigned state for swapping the address assigned to the second memory line with one of the addresses assigned to the part of the first memory lines.

US 9 710 180 B1 discloses a method for controlling wear level operations in solid state memory. The method includes receiving a request to write to a memory location identified by a write address of the solid state memory, generating a write address hash from the write address, making a first determination that a write history for a memory region includes the write address hash, and based on the first determination: clearing the write history, storing the write address hash in the write history, and making a second determination that a wear level operation is due, and based on the second determination: performing the wear level operation.

### Summary

The invention is set out in independent apparatus claim 1 and independent method claim 9. Preferred aspects are defined in dependent claims 2-8, 10-13.

Only embodiments comprising all the features of independent claim 1 or of independent claim 9 fall under the scope of protection of the present present invention.

### Brief Description of the Drawings

Figure 1 illustrates a diagram of a portion of a memory array having a number of physical blocks in accordance with an embodiment of the present disclosure.
Figure 2 is a block diagram of a computing system including a host and an apparatus in the form of a memory device in accordance with an embodiment of the present disclosure.
Figure 3 is a block diagram of circuitry for performing data relocation operations in memory in accordance with an embodiment of the present disclosure.
Figure 4 illustrates a conceptual example of a data relocation operation performed in memory in accordance with an embodiment of the present disclosure.
Figure 5A illustrates a conceptual example of a sequence of data relocation operations performed in memory in accordance with an embodiment of the present disclosure.
Figure 5B is a table of values associated with a sequence of data relocation operations performed in memory in accordance with an embodiment of the present disclosure.

### Detailed Description

The present disclosure includes apparatuses, methods, and systems for data relocation in memory having two portions of data. An embodiment includes a memory having a plurality of physical blocks of memory cells, and a first and second portion of data having a first and second, respectively, number of logical block addresses associated therewith. Two of the plurality of physical blocks of cells do not have data stored therein, wherein one of the two of the plurality of physical blocks of memory cells that do not have data stored therein is located after the first portion of data and before the second portion of data, the other one of the two of the plurality of physical blocks of memory cells that do not have data stored therein is located after the second portion of data and before the first portion of data, and the two of the plurality of physical blocks of memory cells that do not have data stored therein separate the first portion of data and the second portion of data in the memory. Circuitry is configured to relocate the data of the first portion that is associated with a last logical address of the first number of logical block addresses to one of the two physical blocks of cells that do not have data stored therein, relocate the data of the second portion that is associated with a last logical address of the second number of logical block addresses to the other one of the two physical blocks of cells that do not have data stored therein, use algebraic mapping between logical and physical addresses to identify a location in the memory of the one of the two of the plurality of physical blocks of memory cells to which the data of the first portion has been relocated; and use algebraic mapping between logical and physical addresses to identify a location in the memory of the other one of the two of the plurality of physical blocks of memory cells to which the data of the second portion has been relocated .

A wear-leveling operation can include and/or refer to an operation to relocate data currently being stored in one physical location of a memory to another physical location of the memory. Performing such wear-leveling operations can increase the performance (e.g., increase the speed, increase the reliability, and/or decrease the power consumption) of the memory, and/or can increase the endurance (e.g., lifetime) of the memory.

Previous wear-leveling operations may use tables to relocate the data in the memory. However, such tables may be large (e.g., may use a large amount of space in the memory), and may cause the wear-leveling operations to be slow. In contrast, operations (e.g., wear-leveling operations) to relocate data in accordance with the present disclosure may maintain an algebraic mapping (an algebraic mapping between logical and physical addresses) for use in identifying the physical location (e.g., physical block) to which the data has been relocated. Accordingly, operations to relocate data in accordance with the present disclosure may use less space in the memory, and may be faster, than previous wear-leveling operations.

Further, the memory may include (e.g., be separated and/or divided into) two different portions (e.g., logical regions) of data, as will be further described herein. In such instances, previous wear-leveling operations may have to be independently applied to each respective portion of the memory (e.g., separate operations may need to be used for each respective portion), and the data of each respective portion may only be relocated across a fraction of the memory (e.g., the data of each respective portion may remain in separate physical regions of the memory). However, such an approach may be ineffective at increasing the performance and/or endurance of the memory. For instance, since the size of, and/or workload on, the two different logical regions can be different, one of the physical regions may be stressed more than the other one in such an approach.

In contrast, operations (e.g., wear-leveling operations) to relocate data in accordance with the present disclosure may work (e.g., increase performance and/or endurance) more effectively on memory that includes two different portions than previous wear-leveling operations. For example, an operation to relocate data in accordance with the present disclosure may be concurrently applied to each respective portion of the memory (e.g., the same operation can be used on both portions). Further, the data of each respective portion may be relocated across the entire memory (e.g., the data of each respective portion may slide across all the different physical locations of the memory). Accordingly, operations to relocate data in accordance with the present disclosure may be able to account (e.g., compensate) for a difference in size and/or workload of the two portions.

Further, previous wear level operations may not be implementable in hardware. In contrast, operations (e.g., wear-leveling operations) to relocate data in accordance with the present disclosure may be implementable (e.g., completely implementable) in hardware. For instance, operations to relocate data in accordance with the present disclosure may be implementable in the controller of the memory, or within the memory itself. Accordingly, operations to relocate data in accordance with the present disclosure may not impact the latency of the memory, and may not add additional overhead to the memory.

Although embodiments are not limited to a particular type of memory or memory device, operations (e.g., wear-leveling operations) to relocate data in accordance with the present disclosure can be performed (e.g., executed) on a hybrid memory device that includes a first memory array that can be a storage class memory and a number of second memory arrays that can be NAND flash memory. For example, the operations can be performed on the first memory array and/or the second number of memory arrays to increase the performance and/or endurance of the hybrid memory.

As used herein, "a", "an", or "a number of" can refer to one or more of something, and "a plurality of" can refer to one or more such things. For example, a memory device can refer to one or more memory devices, and a plurality of memory devices can refer to two or more memory devices. Additionally, the designators "R", "B", "S", and "N", as used herein, particularly with respect to reference numerals in the drawings, indicates that a number of the particular feature so designated can be included with a number of embodiments of the present disclosure.

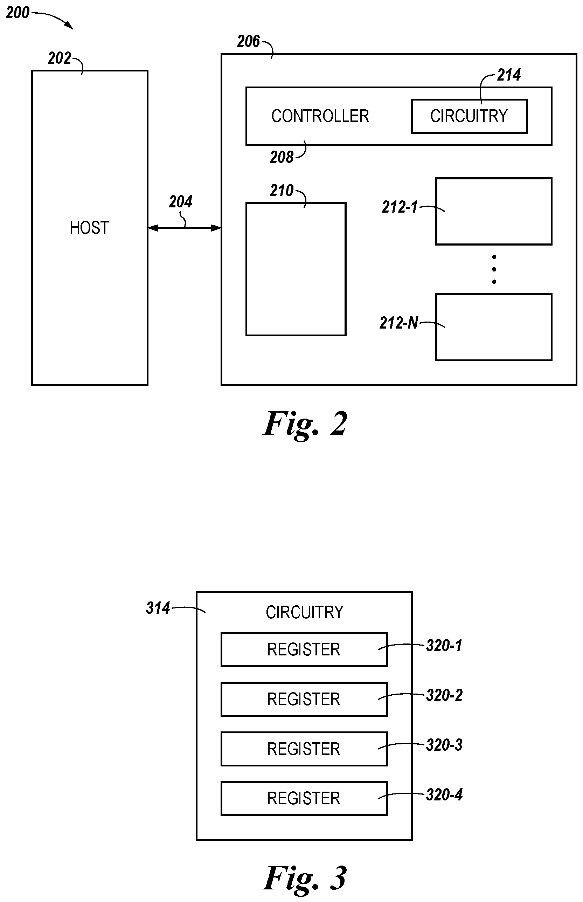

The figures herein follow a numbering convention in which the first digit or digits correspond to the drawing figure number and the remaining digits identify an element or component in the drawing. Similar elements or components between different figures may be identified by the use of similar digits. For example, 214 may reference element "14" in Figure 2, and a similar element may be referenced as 314 in Figure 3.

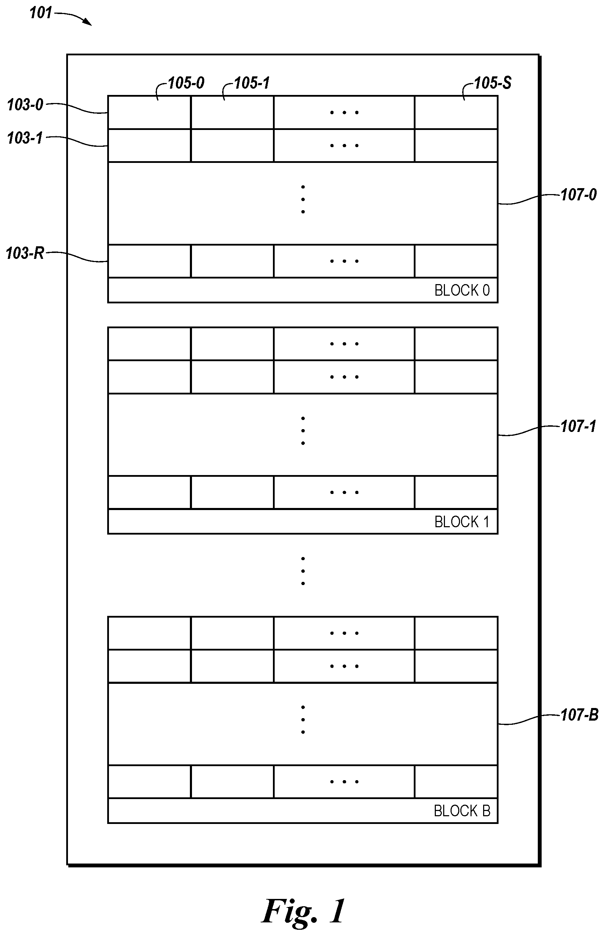

Figure 1 illustrates a diagram of a portion of a memory array 101 having a number of physical blocks in accordance with an embodiment of the present disclosure. Memory array 101 can be, for example, a NAND flash memory array. As an additional example, memory array 101 can be a storage class memory (SCM) array, such as, for instance, a 3D XPoint memory array, a ferroelectric RAM (FRAM) array, or a resistance variable memory array such as a PCRAM, RRAM, or spin torque transfer (STT) array, among others. Memory array 101 can be part of a hybrid memory, as will be further described herein (e.g., in connection with Figure 2). Further, although not shown in Figure 1, memory array 101 can be located on a particular semiconductor die along with various peripheral circuitry associated with the operation thereof.

As shown in Figure 1, memory array 101 has a number of physical blocks 107-0 (BLOCK 0), 107-1 (BLOCK 1), . . ., 107-B (BLOCK B) of memory cells. The memory cells can be single level cells and/or multilevel cells such as, for instance, two level cells, triple level cells (TLCs) or quadruple level cells (QLCs). As an example, the number of physical blocks in memory array 101 may be 128 blocks, 512 blocks, or 1,024 blocks, but embodiments are not limited to a particular power of two or to any particular number of physical blocks in memory array 101.

A number of physical blocks of memory cells (e.g., blocks 107-0, 107-1, . . ., 107-B) can be included in a plane of memory cells, and a number of planes of memory cells can be included on a die. For instance, in the example shown in Figure 1, each physical block 107-0, 107-1, . . ., 107-B can be part of a single die. That is, the portion of memory array 101 illustrated in Figure 1 can be a die of memory cells.

As shown in Figure 1, each physical block 107-0, 107-1, . . ., 107-B includes a number of physical rows (e.g., 103-0, 103-1, . . ., 103-R) of memory cells coupled to access lines (e.g., word lines). The number of rows (e.g., word lines) in each physical block can be 32, but embodiments are not limited to a particular number of rows 103-0, 103-1, . . ., 103-R per physical block. Further, although not shown in Figure 1, the memory cells can be coupled to sense lines (e.g., data lines and/or digit lines).

As one of ordinary skill in the art will appreciate, each row 103-0, 103-1, . . ., 103-R can include a number of pages of memory cells (e.g., physical pages). A physical page refers to a unit of programming and/or sensing (e.g., a number of memory cells that are programmed and/or sensed together as a functional group). In the embodiment shown in Figure 1, each row 103-0, 103-1, . . ., 103-R comprises one physical page of memory cells. However, embodiments of the present disclosure are not so limited. For instance, in an embodiment, each row can comprise multiple physical pages of memory cells (e.g., one or more even pages of memory cells coupled to even-numbered bit lines, and one or more odd pages of memory cells coupled to odd numbered bit lines). Additionally, for embodiments including multilevel cells, a physical page of memory cells can store multiple pages (e.g., logical pages) of data (e.g., an upper page of data and a lower page of data, with each cell in a physical page storing one or more bits towards an upper page of data and one or more bits towards a lower page of data).

In an embodiment of the present disclosure, and as shown in Figure 1, a page of memory cells can comprise a number of physical sectors 105-0, 105-1, ..., 105-S (e.g., subsets of memory cells). Each physical sector 105-0, 105-1, . . ., 105-S of cells can store a number of logical sectors of data. Additionally, each logical sector of data can correspond to a portion of a particular page of data. As an example, a first logical sector of data stored in a particular physical sector can correspond to a logical sector corresponding to a first page of data, and a second logical sector of data stored in the particular physical sector can correspond to a second page of data. Each physical sector 105-0, 105-1, . . ., 105-S, can store system and/or user data, and/or can include overhead data, such as error correction code (ECC) data, logical block address (LBA) data, and metadata.

Logical block addressing is a scheme that can be used by a host for identifying a logical sector of data. For example, each logical sector can correspond to a unique logical block address (LBA). Additionally, an LBA may also correspond (e.g., dynamically map) to a physical address, such as a physical block address (PBA), that may indicate the physical location of that logical sector of data in the memory. A logical sector of data can be a number of bytes of data (e.g., 256 bytes, 512 bytes, 1,024 bytes, or 4,096 bytes). However, embodiments are not limited to these examples. Further, in an embodiment of the present disclosure, memory array 101 can be separated and/or divided into a first logical region of data having a first number of LBAs associated therewith, and a second logical region of data having a second number of LBAs associated therewith, as will be further described herein (e.g., in connection with Figure 2).

It is noted that other configurations for the physical blocks 107-0, 107-1, . . ., 107-B, rows 103-0, 103-1, . . ., 103-R, sectors 105-0, 105-1, . . ., 105-S, and pages are possible. For example, rows 103-0, 103-1, . . ., 103-R of physical blocks 107-0, 107-1, . . ., 107-B can each store data corresponding to a single logical sector which can include, for example, more or less than 512 bytes of data.

Figure 2 is a block diagram of a computing system 200 including a host 202 and an apparatus in the form of a memory device 206 in accordance with an embodiment of the present disclosure. As used herein, an "apparatus" can refer to, but is not limited to, any of a variety of structures or combinations of structures, such as a circuit or circuitry, a die or dice, a module or modules, a device or devices, or a system or systems, for example. Further, in an embodiment, computing system 200 can include a number of memory devices analogous to memory device 206.

In the embodiment illustrated in Figure 2, memory device 206 can include a first type of memory (e.g., a first memory array 210) and a second type of memory (e.g., a number of second memory arrays 212-1,..., 212-N). The memory device 206 can be a hybrid memory device, where memory device 206 includes the first memory array 210 that is a different type of memory than the number of second memory arrays 212-1,..., 212-N. The first memory array 210 can be storage class memory (SCM), which can be a non-volatile memory that acts as main memory for memory device 206 because it has faster access time than the second number of memory arrays 212-1, ..., 212-N. For example, the first memory array 210 can be 3D XPoint memory, FRAM, or resistance variable memory such as PCRAM, RRAM, or STT, among others. The second number of memory arrays 212-1, ..., 212-N can act as a data store (e.g. ,storage memory) for memory device 206, and can be NAND flash memory, among other types of memory.

Although the embodiment illustrated in Figure 2 includes one memory array of the first type of memory, embodiments of the present disclosure are not so limited. For example, in an embodiment, memory device 206 can include a number of SCM arrays. However, memory device 206 may include less of the first type of memory than the second type of memory. For example, memory array 210 may store less data than is stored in memory arrays 212-1, ..., 212-N.

Memory array 210 and memory arrays 212-1, ..., 212-N each have a plurality of physical blocks of memory cells, in a manner analogous to memory array 101 previously described in connection with Figure 1. Further, the memory (e.g., memory array 210, and/or memory arrays 212-1, ..., 212-N) can include (e.g., be separated and/or divided into) two different portions (e.g., logical regions) of data. For instance, the memory includes a first portion of data having a first number (e.g., first quantity) of logical block addresses (LBAs) associated therewith, and a second portion of data having a second number (e.g., second quantity) of LBAs associated therewith. The first number of LBAs can include, for instance, a first sequence of LBAs, and the second number of LBAs can include, for instance, a second sequence of LBAs.

As an example, the first portion of data may comprise user data, and the second portion of data may comprise system data. As an additional example, the first portion of data may comprise data that has been accessed (e.g., data whose associated LBAs have been accessed) at or above a particular frequency during program and/or sense operations performed on the memory, and the second portion of data may comprise data that has been accessed (e.g., data whose associated LBAs have been accessed) below the particular frequency during program and/or sense operations performed on the memory. In such an example, the first portion of data may comprise data that is classified as "hot" data, and the second portion of data may comprise data that is classified as "cold" data. As an additional example, the first portion of data may comprise operating system data (e.g., operating system files), and the second portion of data may comprise multimedia data (e.g., multimedia files). In such an example, the first portion of data may comprise data that is classified as "critical" data, and the second portion of data may comprise data that is classified as "non-critical" data.

The first and second number of LBAs may be the same (e.g., the first and second portions of data may be the same size), or the first number of LBAs may be different than the second number of LBAs (e.g., the sizes of the first portion of data and the second portion of data may be different). For instance, the first number of LBAs may be greater than the second number of LBAs (e.g., the size of the first portion of data may be larger than the size of the second portion of data). Further, the size of each respective one of the first number of LBAs may be the same as the size of each respective one of the second number of LBAs, or the size of each respective one of the first number of LBAs may be different than the size of each respective one of the second number of LBAs. For instance, the size of each respective one of the first number of LBAs may be a multiple of the size of each respective one of the second number of LBAs. Further, the LBAs associated with each respective portion of the memory can be randomized. For instance, the LBAs can be processed by a static randomizer.

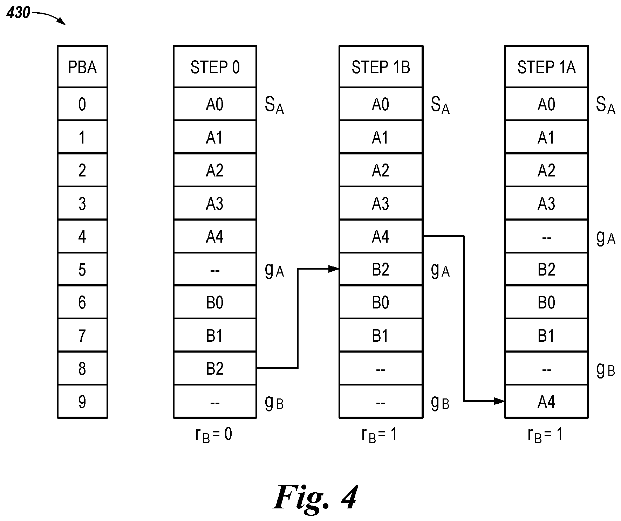

In an embodiment, at least two of the plurality of physical blocks of the memory may not have valid data stored therein. For instance, two of the physical blocks of the memory may be blanks. These physical blocks may separate (e.g., be between) the first portion of data and the second portion of data in the memory. For instance, a first one of these two physical blocks is after the first portion of data and before the second portion of data, and a second one of the two physical blocks is after the second portion and before the first portion. These physical blocks may be referred to herein as separation blocks. An example illustrating a memory having two different portions of data separated by two such separation blocks will be further described herein (e.g., in connection with Figure 4).

As illustrated in Figure 2, host 202 can be coupled to the memory device 206 via interface 204. Host 202 and memory device 206 can communicate (e.g., send commands and/or data) on interface 204. Host 202 can be a laptop computer, personal computer, digital camera, digital recording and playback device, mobile telephone, PDA, memory card reader, or interface hub, among other host systems, and can include a memory access device (e.g., a processor). One of ordinary skill in the art will appreciate that "a processor" can intend one or more processors, such as a parallel processing system, a number of coprocessors, etc.

Interface 204 can be in the form of a standardized physical interface. For example, when memory device 206 is used for information storage in computing system 200, interface 204 can be a serial advanced technology attachment (SATA) physical interface, a peripheral component interconnect express (PCle) physical interface, a universal serial bus (USB) physical interface, or a small computer system interface (SCSI), among other physical connectors and/or interfaces. In general, however, interface 204 can provide an interface for passing control, address, information (e.g., data), and other signals between memory device 206 and a host (e.g., host 202) having compatible receptors for interface 204.

Memory device 206 includes controller 208 to communicate with host 202 and with the first memory array 210 and the number of second memory arrays 212-1,..., 212-N. Controller 208 can send commands to perform operations on the first memory array 210 and the number of second memory arrays 212-1,..., 212-N. Controller 208 can communicate with the first memory array 210 and the number of second memory arrays 212-1,..., 212-N to sense (e.g., read), program (e.g., write), move, and/or erase data, among other operations.

Controller 208 can be included on the same physical device (e.g., the same die) as memories 210 and 212-1, ..., 212-N. Alternatively, controller 208 can be included on a separate physical device that is communicatively coupled to the physical device that includes memories 210 and 212-1, ..., 212-N. In an embodiment, components of controller 208 can be spread across multiple physical devices (e.g., some components on the same die as the memory, and some components on a different die, module, or board) as a distributed controller.

Host 202 can include a host controller to communicate with memory device 206. The host controller can send commands to memory device 206 via interface 204. The host controller can communicate with memory device 206 and/or the controller 208 on the memory device 206 to read, write, and/or erase data, among other operations.

Controller 208 on memory device 206 and/or the host controller on host 202 can include control circuitry and/or logic (e.g., hardware and firmware). In an embodiment, controller 208 on memory device 206 and/or the host controller on host 202 can be an application specific integrated circuit (ASIC) coupled to a printed circuit board including a physical interface. Also, memory device 206 and/or host 202 can include a buffer of volatile and/or non-volatile memory and a number of registers.

For example, as shown in Figure 2, memory device can include circuitry 214. In the embodiment illustrated in Figure 2, circuitry 214 is included in controller 208. However, embodiments of the present disclosure are not so limited. For instance, in an embodiment, circuitry 214 may be included in (e.g., on the same die as) memory 210 and/or memories 212-1, ..., 212-N (e.g., instead of in controller 208).

Circuitry 214 can comprise, for instance, hardware, and can perform wear leveling operations to relocate data stored in memory array 210 and/or memory arrays 212-1, ..., 212-N in accordance with the present disclosure. For example, circuitry 214 can relocate the data of the first portion of data that is associated with a particular one of the first number of LBAs to one of the two separation blocks, and can relocate the data of the second portion of data that is associated with a particular one of the second number of LBAs to the other one of the two separation blocks.

For instance, circuitry 214 can relocate the data of the first portion that is associated with the last one of the first number of LBAs (e.g., the last LBA in the first sequence of LBAs) to the second separation block (e.g., the separation block that is after the second portion and before the first portion), and circuitry 214 can relocate the data of the second portion that is associated with the last one of the second number of LBAs (e.g., the last LBA in the second sequence of LBAs) to the first separation block (e.g., the separation block that is after the first portion and before the second portion). Such a data relocation may result in two different physical blocks of the memory having no valid data stored therein (e.g., may result in two different physical blocks of the memory becoming the separation blocks). For instance, relocating the data of the first portion associated with the last one of the first number of LBAs may result in a different physical block becoming the separation block that is after the second portion and before the first portion, and relocating the data of the second portion associated with the last one of the second number of LBAs may result in a different physical block becoming the separation block that is after the first portion and before the second portion. Further, relocating the data of the first portion associated with the last one of the first number of LBAs may result in a different one of the first number of LBAs (e.g., the next-to-last LBA in the first sequence of LBAs) becoming the last one of the first number of LBAs, and relocating the data of the second portion associated with the last one of the second number of LBAs may result in a different one of the second number of LBAs (e.g., the next-to-last LBA in the second sequence of LBAs) becoming the last one of the second number of LBAs. An example illustrating such a data relocation operation will be further described herein (e.g., in connection with Figures 3 and 4).

In an embodiment, circuitry 214 may perform an operation to relocate the data responsive to a triggering event. The triggering event may be, for example, a particular number of program operations, such as, for instance, 100 program operations, being performed (e.g., executed) on the memory. For instance, a counter (not shown in Figure 2) can be configured to send an initiation signal in response to the particular number of program operations being performed, and circuitry 214 may perform the operation to relocate the data in response to receiving the initiation signal from the counter. As an additional example, the triggering event may be a power state transition occurring in the memory, such as, for instance, memory device 206 going from active mode to stand-by mode, idle mode, or power-down mode.

In an embodiment, the data of the second portion may be relocated immediately upon the data of the first portion being relocated. However, in some instances, the operation to relocate the data may need to be suspended in order to perform an operation, such as a program or sense operation, requested by host 202. In such an instance, the operation requested by the host can be performed upon the data of the first portion being relocated (e.g., upon the relocation of the data being completed), and the data of the second portion may be relocated upon the requested operation being performed (e.g., upon the operation being completed).

Once the data has been relocated, circuitry 214 can use algebraic mapping to identify the physical location in the memory to which the data has been relocated. For example, circuitry 214 can use algebraic mapping (e.g., algebraic logical to physical mapping) to identify (e.g., compute) the location in the memory (e.g., the PBA) of the physical block to which the data of the first portion has been relocated (e.g., the location of the second separation block), and the location in the memory (e.g., the PBA) of the physical block to which the data in the second portion of the memory has been relocated (e.g., the location of the first separation block). For instance, circuitry 214 can use the algebraic mapping to identify the location in the memory of the physical block to which the data of the first portion has been relocated during an operation to sense that relocated data (e.g., upon receiving a request from host 202 to read one of the first number of LBAs), and to identify the location in the memory of the physical block to which the data of the second portion has been relocated during an operation to sense that relocated data (e.g., upon receiving a request from host 202 to read one of the second number of LBAs). Such an algebraic mapping will be further described herein (e.g., in connection with Figure 3).

Circuitry 214 can perform additional (e.g., subsequent) wear leveling operations to further relocate the data stored in memory array 210 and/or memory arrays 212-1, ..., 212-N throughout the lifetime of the memory. For instance, circuitry 214 can perform an additional (e.g., subsequent) operation to relocate the data responsive to an additional (e.g., subsequent) triggering event.

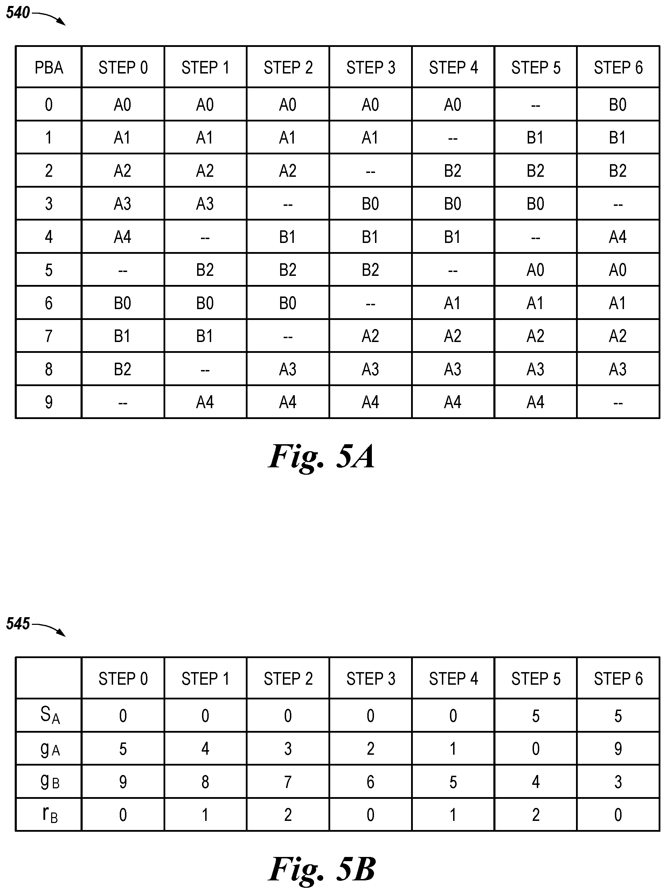

For example, in an operation to relocate data in the memory that is performed subsequent to the example operation previously described herein, circuitry 214 can relocate the data of the first portion that is associated with the different one of the first number of LBAs that has now become the last one (e.g., the one that was previously the next-to-last LBA in the first sequence of LBAs) to the different physical block that has now become the separation block that is after the second portion and before the first portion, and circuitry 214 can relocate the data of the second portion that is associated with the different one of the second number of LBAs that has now become the last one (e.g., the one that was previously the next-to-last LBA in the second sequence of LBAs) to the different physical block that has now become the separation block that is after the first portion and before the second portion. Such a data relocation may once again result in two different physical blocks of the memory becoming the separation blocks, and different ones of the first and second number of LBAs becoming the last one of the first and second number of LBAs, respectively, and subsequent data relocation operations can continue to be performed in an analogous manner. An example illustrating a sequence of such subsequent data relocation operations will be further described herein (e.g., in connection with Figures 5A-5B).

The embodiment illustrated in Figure 2 can include additional circuitry, logic, and/or components not illustrated so as not to obscure embodiments of the present disclosure. For example, memory device 206 can include address circuitry to latch address signals provided over I/O connectors through I/O circuitry. Address signals can be received and decoded by a row decoder and a column decoder, to access memory arrays 210 and 212-1, ..., 212-N. Further, memory device 206 can include a main memory, such as, for instance, a DRAM or SDRAM, that is separate from and/or in addition to memory arrays 210-1 and 212-1, ..., 212-N.

Figure 3 is a block diagram of circuitry 314 for performing data relocation operations in memory in accordance with an embodiment of the present disclosure. Circuitry 314 can be, for example, circuitry 214 previously described in connection with Figure 2.

As shown in Figure 3, circuitry 314 can include four registers (e.g., a first register 320-1, a second register 320-2, a third register 320-3, and a fourth register 320-4). Register 320-1 can store a value indicating (e.g., pointing to) the PBA for the data of the first portion of the memory that is associated with the first one of the first number of LBAs (e.g., the first LBA in the first sequence of LBAs). This value can be referred to herein as "S_{A}".

Register 320-2 can store a value indicating the PBA for one of the two physical blocks of the memory that do not have data stored therein, and register 320-3 can store a value indicating the PBA for the other one of the two physical blocks that do not have data stored therein. For example, register 320-2 can store a value indicating the PBA for the physical block that is after the first portion of data and before the second portion of data (e.g., the first separation block), and register 320-3 can store a value indicating the PBA for the physical block that is after the second portion and before the first portion (e.g., the second separation block). The value stored by register 320-2 can be referred to herein as "g_{A}", and the value stored by register 320-3 can be referred to herein as "gs".

Register 320-4 can store a value indicating the relative position of the first one of the second number of LBAs (e.g., the first LBA in the second sequence of LBAs) in the second portion of the data of the memory. This value can be referred to herein as "rs"

Circuitry 314 can use the values stored in registers 320-1, 320-2, 320-3, and 320-4 (e.g., S_{A}, g_{A}, g_{B}, and r_{B}) to perform a data relocation operation in memory accordance with the present disclosure. For instance, circuitry 314 can use the below example of code, representing executable instructions, to perform a data relocation operation in accordance with the present disclosure. In the below example, "n_{PBA"} represents the total number (e.g., quantity) of PBAs in the memory, "n_{A}" represents the total number of LBAs associated with the first portion of data (e.g., the first number of LBAs), "n_{B}" represents the total number of LBAs associated with the second portion of data (e.g., the second number of LBAs), and "sep" represents the number of PBAs for each respective separation block.
1: procedure STEP
2: Do StepB
3: Do StepA
4: end procedure

1: procedure StepB
2: Move the content of the PBA g_{B} - 1 (mod n_{PBA}) into g_{A} + sep - 1 (mod n_{PBA})
3: g_{B} ← g_{B} - 1 (mod n_{PBA})
4: r_{B} ← r_{B} + 1 (mod n_{B})
5: end procedure

1: procedure StepA
2: Move the content of the PBA g_{A} - 1 (mod n_{PBA}) into g_{B} + sep (mod n_{PBA})
3: g_{A} ← g_{A} - 1 (mod n_{PBA})
4: if g_{A} = S_{A} then
5: S_{A} ← S_{A} + n_{B} + 2sep (mod n_{PBA})
6: end if
7: end procedure

Further, circuitry 314 can use the values stored in registers 320-1, 320-2, 320-3, and 320-4 (e.g., S_{A}, g_{A}, g_{B}, and r_{B}) to perform an algebraic mapping (e.g., an algebraic logical to physical mapping) to identify the physical location in the memory (e.g., the PBA) to which the data has been relocated (e.g., during a sense operation, as previously described herein). For instance, circuitry 314 can compute the PBA, represented below as "p", for any LBA, represented below as "I", associated with the first portion of data using the below "First Portion Mapping", and circuitry 314 can compute the PBA for any LBA associated with the second portion of data using the below "Second Portion Mapping":
First Portion Mapping $p = \left\{\begin{matrix}\left(I+{S}_{A}\right) mod {n}_{PBA} & if \left(\left(I+{S}_{A}\right) mod {n}_{PBA}<{g}_{A}\right) OR \left({g}_{A}<{S}_{A}\right) \\ \left(I+{S}_{A}+2sep+{n}_{B}\right) mod {n}_{PBA} & else\end{matrix}\right.$ where $I ∈ \left\{0,…,{n}_{A}-1\right\}$
Second Portion Mapping $p = \left(\left(I+{r}_{B}\right) mod {n}_{B}+{g}_{A}+sep\right) mod {n}_{PBA}$ where $I ∈ \left\{0,…,{n}_{B}-1\right\}$

Figure 4 illustrates a conceptual example 430 of a data relocation operation performed in memory in accordance with an embodiment of the present disclosure. The memory may be, for example, memory array 210 and/or memory arrays 212-1, ..., 212-N previously described in connection with Figure 2, and the data relocation operation may be performed by, for example, circuitry 214 and/or 314 previously described in connection with Figures 2 and 3, respectively.

In the example illustrated in Figure 4, the memory includes ten physical blocks of memory cells, represented by PBAs 0 through 9 (e.g., PBA 0 corresponds to the first physical block, PBA 1 corresponds to the second physical block, PBA 2 corresponds to the third physical block, etc.). Further, in the example illustrated in Figure 4, the memory includes (e.g., is separated and/or divided into) two different portions (e.g., logical regions) of data, which can be referred to as portion A and portion B. As shown in Figure 4, the data of portion A has five LBAs associated therewith (e.g., LBAs A0 through A4), and the data of portion B has three LBAs associated therewith (e.g., LBAs B0 through B2). In the example illustrated in Figure 4, the LBA size is the same for portion A and portion B. Further, "S_{A}" shown in Figure 4 indicates the PBA for the data of portion A associated with LBA A0, and "r_{B}" shown in Figure 4 indicates the relative position of LBA B0 in portion B (e.g., the relative position of LBA B0 in the sequence of LBAs associated with portion B).

Further, in the example illustrated in Figure 4, two of the physical blocks of the memory do not have valid data stored therein, and separate (e.g., are between) portion A and portion B. These blocks may be referred to as separation blocks (as previously described herein), and are represented in Figure 4 by a "--" symbol. In the example illustrated in Figure 4, "g_{A}" indicates the PBA for the separation block that is after portion A and before portion B, and "g_{B}" indicates the PBA for the separation block that is after portion B and before portion A.

In the example illustrated in Figure 4, each respective separation block comprises one PBA, which is the same size as the LBA sizes for portions A and B. However, in an example in which the LBA sizes for portions A and B are different, such as, for instance, in which the size of one portion is a multiple of the other, the number of PBAs in each separation block may be equal to that multiple. For instance, if the LBA size for portion B is equal to the PBA size, but the LBA size for portion A is four PBAs, the number of PBAs in each separation block would be four.

The column labelled "Step 0" in Figure 4 shows the data allocation within the memory before the data relocation operation is performed. For instance, as illustrated in Figure 4, before the data relocation operation is performed the data of portion A is located in PBAs 0 through 4, the data of portion B is located in PBAs 6 through 8, the separation block that is after portion A and before portion B is located at PBA 5 (e.g., as indicated by g_{A}), and the separation block that is after portion B and before portion A is located at PBA 9 (e.g., as indicated by g_{B}). Further, the relative position of LBA B0 in portion B before the data relocation operation is performed is first (e.g., LBA B0 is first in the sequence of LBAs associated with portion B, as indicated by the value for r_{B}), as illustrated in Figure 4.

The data relocation operation can be divided into two substeps, which are represented by the "Step 1B" and "Step 1A" columns in Figure 4. As shown in Figure 4, during the first substep (e.g., Step 1B), the data of portion B associated with the last of the LBAs of portion B (e.g., the data associated with LBA B2) is relocated to the separation block that is after portion A and before portion B (e.g., to the separation block indicated by g_{A}). That is, the first substep (e.g., Step 1B) moves the data associated with the last of the LBAs of portion B up, to be before the first of the LBAs of portion B (e.g., the data associated with LBA B2 is moved up to be before the data associated with LBAs B0 and B1). During the second substep (e.g., Step 1A), the data of portion A associated with the last of the LBAs of portion A (e.g., the data associated with LBA A4) is relocated to the separation block that is after portion B and before portion A (e.g., to the separation block indicated by g_{B}), as illustrated in Figure 4. That is, the second substep moves the data associated with last of the LBAs of portion A down, to be after the LBAs of portion B (e.g., the data associated with LBA A4 is moved down to be after the data associated with LBAs B2, B0, and B1).

As a result of the data relocation operation (e.g., after Steps 1B and 1A are performed), PBA 4 becomes the separation block that is after portion A and before portion B, and PBA 8 becomes the separation block that is after portion B and before portion A, as illustrated in Figure 4 (e.g. as indicated by g_{A} and g_{B}, respectively, after Step 1B). Also as a result of the data relocation operation, the next-to-last of the LBAs of portion A (e.g., LBA A3) becomes the last of the LBAs of portion A before portion B, and the next-to-last of the LBAs of portion B (e.g.,, LBA B1) becomes the last of the LBAs of portion B, as illustrated in Figure 4). Also as a result of the data relocation operation, the data of portion A becomes located in PBAs 0 through 3 and 9, and the data of portion B becomes located in PBAs 5 through 7, as illustrated in Figure 4. Also as a result of the data relocation operation, the relative position of LBA B0 in portion B becomes second (e.g., LBA B0 becomes second in the sequence of LBAs associated with portion B, as indicated by the value for r_{B}), as illustrated in Figure 4.

In the example illustrated in Figure 4, each subset is run once during the data relocation operation. However, in an example in which the LBA sizes for portions A and B are different, such as, for instance, in which the size of one portion is a multiple of the other, Step 1A and/or Step 1B may need to be run more than once. For instance, in an example in which the LBA size for portion B is equal to the PBA size, but the LBA size for portion A is four PBAs, Step 1B would be run four times, and Step 1A would be run once.

Figure 5A illustrates a conceptual example 540 of a sequence of data relocation operations performed in memory in accordance with an embodiment of the present disclosure. The memory is analogous to the memory previously described in connection with Figure 4, and the data relocation operations may be performed by, for example, circuitry 214 and/or 314 previously described in connection with Figures 2 and 3, respectively. Figure 5B is a table 545 of values for S_{A}, g_{A}, g_{B}, and r_{B} associated with the sequence of data relocation operations. S_{A}, g_{A}, g_{B}, and r_{B} are analogous to S_{A}, g_{A}, g_{B}, and r_{B}, respectively, previously described in connection with Figure 4. Each "Step" column in Figures 5A and 5B represents the effect of performing both substep B and subset A (e.g., "Step 1" is the combination of substep 1B and substep 1A described in connection with Figure 4).

The column labelled "Step 0" in Figure 5A shows the data allocation within the memory before the first data relocation operation of the sequence is performed, and is analogous to the "Step 0" column described in connection with Figure 4. For example, as shown in Figure 5B, the values for S_{A}, g_{A}, g_{B}, and r_{B} in the Step 0 column (e.g., before the first data relocation operation is performed) are 0, 5, 9, and 0, respectively, as described in connection with Figure 4.

The columns labelled "Step 1" through "Step 6" in Figure 5A show the data allocation within the memory after the performance of each respective data relocation operation in the sequence. For example, the Step 1 column shows the data allocation after the performance of the first data relocation operation, and is analogous to the combined effect of substep 1B and substep 1A described in connection with Figure 4. The Step 2 column shows the data allocation after the performance of the second data relocation operation, the Step 3 column shows the data allocation after the performance of the third data relocation operation, etc. Further, the columns labelled "Step 1" through "Step 6" in Figure 5B show the values for S_{A}, g_{A}, g_{B}, and r_{B} after the performance of each respective data relocation operation in the sequence. For example, the data allocation and values shown in the Step 1 columns in Figures 5A and 5B, respectively, are analogous to the data allocation and S_{A}, g_{A}, g_{B}, and r_{B} values after the relocation operation described in connection with Figure 4.

As shown in the Step 2 column of Figure 5A, after the performance of the second data relocation operation in the sequence, the data of portion B that was associated with the last of the LBAs of portion B after Step 1 (e.g., the data associated with LBA B1) is relocated to the separation block that was after portion A and before portion B after Step 1 (e.g., to PBA 4), and the data of portion A that was associated with the last of the LBAs of portion A after Step 1 (e.g., the data associated with LBA A3) is relocated to the separation block that was after portion B and before portion A after Step 1 (e.g., to PBA 8). Further, as shown in the Step 2 column of Figure 5A, PBA 3 has become the separation block that is after portion A and before portion B, and PBA 7 has become the separation block that is after portion B and before portion A, as indicated by the values for g_{A} and g_{B}, respectively, in the Step 2 column of Figure 5B. Further, as shown in the Step 2 column of Figure 5A, the LBA that was the next-to-last of the LBAs of portion A after Step 1 (e.g., LBA A2) has become the last of the LBAs of portion A before portion B, and the LBA that was the next-to-last of the LBAs of portion B after Step 1 (e.g.,, LBA B0) has become the last of the LBAs of portion B. Further, as shown in the Step 2 column of Figure 5A, the data of portion A has become located in PBAs 0 through 2 and 8 through 9, and the data of portion B has become located in PBAs 4 through 6, with the PBA for the data of portion A associated with LBA A0 remaining at PBA 0, as indicated by the value for S_{A} in the Step 2 column of Figure 5B. Further, as shown in the Step 2 column of Figure 5A, the relative position of LBA B0 in portion B has become third, as indicated by the value for r_{B} in the Step 2 column of Figure 5B.

As shown in the Step 3 column of Figure 5A, after the performance of the third data relocation operation in the sequence, the data of portion B that was associated with the last of the LBAs of portion B after Step 2 (e.g., the data associated with LBA B0) is relocated to the separation block that was after portion A and before portion B after Step 2 (e.g., to PBA 3), and the data of portion A that was associated with the last of the LBAs of portion A after Step 2 (e.g., the data associated with LBA A2) is relocated to the separation block that was after portion B and before portion A after Step 2 (e.g., to PBA 7). Further, as shown in the Step 2 column of Figure 5A, PBA 2 has become the separation block that is after portion A and before portion B, and PBA 6 has become the separation block that is after portion B and before portion A, as indicated by the values for g_{A} and g_{B}, respectively, in the Step 3 column of Figure 5B. Further, as shown in the Step 3 column of Figure 5A, the LBA that was the next-to-last of the LBAs of portion A after Step 2 (e.g., LBA A1) has become the last of the LBAs of portion A, and the LBA that was the next-to-last of the LBAs of portion B after Step 2 (e.g.,, LBA B2) has become the last of the LBAs of portion B. Further, as shown in the Step 3 column of Figure 5A, the data of portion A has become located in PBAs 0 through 1 and 7 through 9, and the data of portion B has become located in PBAs 3 through 5, with the PBA for the data of portion A associated with LBA A0 remaining at PBA 0, as indicated by the value for S_{A} in the Step 3 column of Figure 5B. Further, as shown in the Step 3 column of Figure 5A, the relative position of LBA B0 in portion B has become first, as indicated by the value for r_{B} in the Step 3 column of Figure 5B.

The fourth, fifth, and sixth data relocation operations of the sequence can continue in an analogous manner, as shown in the Step 4, Step 5, and Step 6 columns, respectively, in Figures 5A and 5B. As such, it can be seen that the effect of the data relocation operations is to sequentially move the data associated with the last of the LBAs of portion B up to be before the first of the LBAs of portion B, and sequentially move the data associated with last of the LBAs of portion A down to be after the LBAs of portion B, such that portion B moves up and portion A moves down throughout the operation of the memory. Accordingly, not only do the data relocation operations of the sequence move the data associated with each respective LBA to a different PBA throughout the operation of the memory, but the two different portions of data are not static (e.g., the PBAs at which the data of each respective portion are located continue to change throughout the operation of the memory). That is, the data of each respective portion may be relocated across the entire memory throughout the operation of the memory.

Each respective data relocation operation in the sequence can be performed responsive to a separate triggering event, as previously described herein (e.g., in connection with Figure 2). Although the example sequence illustrated in Figures 5A-5B includes six data relocation operations, embodiments of the present disclosure are not so limited. For instance, additional data relocation operations can continue to be performed (e.g., responsive to subsequent triggering events) in an analogous manner throughout the lifetime of the memory.

This disclosure is intended to cover adaptations or variations of a number of embodiments of the present disclosure. It is to be understood that the above description has been made in an illustrative fashion, and not a restrictive one. 14815861-1

In the foregoing Detailed Description, some features are grouped together in a single embodiment for the purpose of streamlining the disclosure. This method of disclosure is not to be interpreted as reflecting an intention that the disclosed embodiments of the present disclosure have to use more features than are expressly recited in each claim. Rather, as the following claims reflect, inventive subject matter lies in less than all features of a single disclosed embodiment. Thus, the following claims are hereby incorporated into the Detailed Description, with each claim standing on its own as a separate embodiment. For the avoidance of doubt, the scope of protection of the present invention is defined by appended claims 1-13.

## Claims

1. An apparatus (206), comprising:
a memory (210, 212-1, ..., 212-N) having a plurality of physical blocks (107-0, 107-1, . . ., 107-B) of memory cells, wherein:
the memory (210, 212-1, ..., 212-N) includes a first portion of data having a first number of logical block addresses associated therewith, and a second portion of data having a second number of logical block addresses associated therewith; and
two of the plurality of physical blocks (107-0, 107-1, ..., 107-B) of memory cells do not have data stored therein, wherein:
one of the two of the plurality of physical blocks (107-0, 107-1, .. ., 107-B) of memory cells that do not have data stored therein is located after the first portion of data and before the second portion of data;
the other one of the two of the plurality of physical blocks (107-0, 107-1, . . ., 107-B) of memory cells that do not have data stored therein is located after the second portion of data and before the first portion of data; and
the two of the plurality of physical blocks (107-0, 107-1, . . ., 107-B) of memory cells that do not have data stored therein separate the first portion of data and the second portion of data in the memory (210, 212-1, ..., 212-N); and
circuitry (214, 314) configured to:
relocate the data of the first portion that is associated with a last logical block address of the first number of logical block addresses to one of the two of the plurality of physical blocks (107-0, 107-1, . . ., 107-B) of memory cells that do not have data stored therein; and
relocate the data of the second portion that is associated with a last logical block address of the second number of logical block addresses to the other one of the two of the plurality of physical blocks (107-0, 107-1, . . ., 107-B) of memory cells that do not have data stored therein;
use algebraic mapping between logical and physical addresses to identify a location in the memory (210, 212-1, ..., 212-N) of the one of the two of the plurality of physical blocks (107-0, 107-1, . . ., 107-B) of memory cells to which the data of the first portion has been relocated; and
use algebraic mapping between logical and physical addresses to identify a location in the memory (210, 212-1, ..., 212-N) of the other one of the two of the plurality of physical blocks (107-0, 107-1, ..., 107-B) of memory cells to which the data of the second portion has been relocated.

2. The apparatus (206) of claim 1, wherein:
the first portion of data comprises user data; and
the second portion of data comprises system data.

3. The apparatus (206) of claim 1, wherein:
the first portion of data comprises data that has been accessed at or above a particular frequency during program or sense operations performed on the memory (210, 212-1, . . ., 212-N); and
the second portion of data comprises data that has been accessed below the particular frequency during program or sense operations performed on the memory (210, 212-1, . . ., 212-N).

4. The apparatus (206) of claim 1, wherein:
the first portion of data comprises operating system data; and
the second portion of data comprises multimedia data.

5. The apparatus (206) of claim 1, wherein a size of each respective one of the first number of logical block addresses is different than a size of each respective one of the second number of logical block addresses.

6. The apparatus (206) of claim 1, wherein the circuitry is included in the memory (210, 212-1, . . ., 212-N).

7. The apparatus (206) of claim 1, comprising a controller (208), wherein the circuitry is included in the controller (208).

8. The apparatus of claim 1, wherein the circuitry includes:
a first register (320-1) configured to store a value indicating a physical block address for the data of the first portion that is associated with a first one of the first number of logical block addresses;
a second register (320-2) configured to store a value indicating a physical block address for one of the two of the plurality of physical blocks (107-0, 107-1, . . ., 107-B) of memory cells that do not have data stored therein;
a third register (320-3) configured to store a value indicating a physical block address for the other one of the two of the plurality of physical blocks (107-0, 107-1, .. ., 107-B) of memory cells that do not have data stored therein; and
a fourth register (320-4) configured to store a value indicating a relative position of a first one of the second number of logical block addresses in the second portion of data.

9. A method of operating a memory (210, 212-1, ..., 212-N), the method comprising:
relocating data included in a first portion of the memory and associated with a last logical block address of a number of logical block addresses of the first portion of the memory (210, 212-1, ..., 212-N) to a physical block (107-0, 107-1, . . ., 107-B) of the memory that has no data stored therein; and
relocating data included in a second portion of the memory and associated with a last logical block address of a number of logical block addresses of the second portion of the memory (210, 212-1, ..., 212-N) to another physical block (107-0, 107-1, ..., 107-B) of the memory that has no data stored therein,
wherein the physical block (107-0, 107-1, . . ., 107-B) of the memory (210, 212-1, ..., 212-N) that has no data stored therein is located after the first portion of the memory and before the second portion of the memory;
wherein the another physical block (107-0, 107-1, . . ., 107-B) of the memory (210, 212-1, ..., 212-N) that has no data stored therein is located after the second portion of the memory (210, 212-1, ..., 212-N) and before the first portion of the memory (210, 212-1, . . ., 212-N);
wherein the physical block (107-0, 107-1, . . ., 107-B) of the memory (210, 212-1, ..., 212-N) that has no data stored therein and the another physical block of the memory (210, 212-1, ..., 212-N) that has no data stored therein separate the first portion of the memory and the second portion of the memory (210, 212-1, ..., 212-N); and
wherein the method further includes:
using algebraic mapping between logical and physical addresses to identify a location in the memory (210, 212-1, ..., 212-N) of the physical block (107-0, 107-1, . . ., 107-B) to which the data in the first portion of the memory (210, 212-1, ..., 212-N) has been relocated; and
using algebraic mapping between logical and physical addresses to identify a location in the memory (210, 212-1, ..., 212-N) of the another physical block (107-0, 107-1, . . ., 107-B) to which the data in the second portion of the memory (210, 212-1, . . ., 212-N) has been relocated.

10. The method of claim 9, wherein the method includes:
using the algebraic mapping between logical and physical addresses to identify the location in the memory (210, 212-1, ..., 212-N) of the physical block (107-0, 107-1, . . ., 107-B) to which the data in the first portion of the memory (210, 212-1, ..., 212-N) has been relocated during an operation to sense that relocated data; and
using the algebraic mapping between logical and physical addresses to identify the location in the memory (210, 212-1, ..., 212-N) of the another physical block (107-0, 107-1, . . ., 107-B) to which the data in the second portion of the memory (210, 212-1, ..., 212-N) has been relocated during an operation to sense that relocated data.

11. The method of claim 9, wherein the method includes relocating the data included in the first portion of the memory (210, 212-1, ..., 212-N) and relocating the data included in the second portion of the memory (210, 212-1, ..., 212-N) responsive to a triggering event.

12. The method of claim 11, wherein the triggering event is a particular number of program operations being performed on the memory (210, 212-1, ..., 212-N) or is a power state transition occurring in the memory (210, 212-1, ..., 212-N).

13. The method of claim 9, wherein;
relocating the data included in the first portion of the memory (210, 212-1, . . ., 212-N) to the physical block (107-0, 107-1, . . ., 107-B) of the memory (210, 212-1, ..., 212-N) results in a third physical block (107-0, 107-1, . . ., 107-B) of the memory (210, 212-1, ..., 212-N) having no data stored therein; and
relocating the data included in the second portion of the memory (210, 212-1, .. ., 212-N) to the another physical block (107-0, 107-1, . . ., 107-B) of the memory (210, 212-1, ..., 212-N) results in a fourth physical block (107-0, 107-1, . . ., 107-B) of the memory (210, 212-1, ..., 212-N) having no data stored therein; and
the method further includes:
relocating data included in the first portion of the memory (210, 212-1, .. ., 212-N) and associated with a different one of the number of logical block addresses of the first portion of the memory (210, 212-1, ..., 212-N) to the third physical block (107-0, 107-1, . . ., 107-B) of the memory (210, 212-1, . . ., 212-N); and
relocating data included in the second portion of the memory (210, 212-1, ..., 212-N) and associated with a different one of the number of logical block addresses of the second portion of the memory (210, 212-1, ..., 212-N) to the fourth physical block (107-0, 107-1, . . ., 107-B) of the memory (210, 212-1, ..., 212-N).

## Patentansprüche

1. Einrichtung (206), umfassend:
einen Speicher (210, 212-1, . . ., 212-N), der eine Vielzahl von physischen Blöcken (107-0, 107-1, . . ., 107-B) von Speicherzellen aufweist, wobei:
der Speicher (210, 212-1, . . ., 212-N) einen ersten Datenteil, der eine erste Anzahl damit verknüpfter logischer Blockadressen aufweist, und einen zweiten Datenteil, der eine zweite Anzahl damit verknüpfter logischer Blockadressen aufweist, beinhaltet; und
zwei der Vielzahl von physischen Blöcken (107-0, 107-1, . . ., 107-B) von Speicherzellen keine darin gespeicherten Daten aufweisen, wobei:
einer der zwei der Vielzahl von physischen Blöcken (107-0, 107-1, . . ., 107-B) von Speicherzellen, die keine Daten darin gespeichert aufweisen, sich nach dem ersten Datenteil und vor dem zweiten Datenteil befindet;
der andere der zwei der Vielzahl von physischen Blöcken (107-0, 107-1, . . ., 107-B) von Speicherzellen, die keine Daten darin gespeichert aufweisen, sich nach dem zweiten Datenteil und vor dem ersten Datenteil befindet; und
die zwei der Vielzahl von physischen Blöcken (107-0, 107-1, . . ., 107-B) von Speicherzellen, die keine Daten darin gespeichert aufweisen, den ersten Datenteil und den zweiten Datenteil im Speicher (210, 212-1, . . ., 212-N) trennen; und
Schaltung (214, 314), die für Folgendes konfiguriert ist:
Verschieben der Daten des ersten Teils, der mit einer letzten logischen Blockadresse der ersten Anzahl von logischen Blockadressen verknüpft ist, zu einem der zwei der Vielzahl von physischen Blöcken (107-0, 107-1, . . ., 107-B) von Speicherzellen, die keine Daten darin gespeichert aufweisen; und
Verschieben der Daten des zweiten Teils, der mit einer letzten logischen Blockadresse der zweiten Anzahl von logischen Blockadressen verknüpft ist, zu dem anderen der zwei der Vielzahl von physischen Blöcken (107-0, 107-1, . . ., 107-B) von Speicherzellen, die keine Daten darin gespeichert aufweisen;
Verwenden algebraischer Zuordnung zwischen logischen und physischen Adressen, um eine Stelle im Speicher (210, 212-1, . . ., 212-N) des einen der zwei physischen Blöcke (107-0, 107-1, . . ., 107-B) von Speicherzellen zu identifizieren, zu der die Daten des ersten Teils verschoben wurden; und
Verwenden algebraischer Zuordnung zwischen logischen und physischen Adressen, um eine Stelle im Speicher (210, 212-1, . . ., 212-N) des anderen der zwei physischen Blöcke (107-0, 107-1, . . ., 107-B) von Speicherzellen zu identifizieren, zu der die Daten des zweiten Teils verschoben wurden.

2. Einrichtung (206) nach Anspruch 1, wobei:
der erste Datenteil Benutzerdaten umfasst; und
der zweite Datenteil Systemdaten umfasst.

3. Einrichtung (206) nach Anspruch 1, wobei:
der erste Datenteil Daten umfasst, auf die während am Speicher (210, 212-1, . . ., 212-N) durchgeführten Programmier- oder Leseoperationen mit oder über einer bestimmten Frequenz zugegriffen wurde; und
der zweite Datenteil Daten umfasst, auf die während am Speicher (210, 212-1, . . ., 212-N) durchgeführten Programmier- oder Leseoperationen unter der bestimmten Frequenz zugegriffen wurde.

4. Einrichtung (206) nach Anspruch 1, wobei:
der erste Datenteil Betriebssystemdaten umfasst; und
der zweite Datenteil Multimediadaten umfasst.

5. Einrichtung (206) nach Anspruch 1, wobei sich eine Größe jeder einzelnen der ersten Anzahl logischer Blockadressen von einer Größe jeder einzelnen der zweiten Anzahl logischer Blockadressen unterscheidet.

6. Einrichtung (206) nach Anspruch 1, wobei die Schaltung im Speicher (210, 212-1, . . ., 212-N) beinhaltet ist.

7. Einrichtung (206) nach Anspruch 1, die eine Steuereinheit (208) umfasst, wobei die Schaltung in der Steuereinheit (208) beinhaltet ist.

8. Einrichtung nach Anspruch 1, wobei die Schaltung Folgendes beinhaltet:
ein erstes Register (320-1), das so konfiguriert ist, dass es einen Wert speichert, der eine physische Blockadresse für die Daten des ersten Teils angibt, der mit einer ersten der ersten Anzahl logischer Blockadressen verknüpft ist;
ein zweites Register (320-2), das so konfiguriert ist, dass es einen Wert speichert, der eine physische Blockadresse für einen der zwei der Vielzahl von physischen Blöcken (107-0, 107-1, . . ., 107-B) von Speicherzellen angibt, die keine Daten darin gespeichert aufweisen;
ein drittes Register (320-3), das so konfiguriert ist, dass es einen Wert speichert, der eine physische Blockadresse für den anderen der zwei der Vielzahl von physischen Blöcken (107-0, 107-1, . . ., 107-B) von Speicherzellen angibt, die keine Daten darin gespeichert aufweisen; und
ein viertes Register (320-4), das so konfiguriert ist, dass es einen Wert speichert, der eine relative Position einer ersten der zweiten Anzahl logischer Blockadressen im zweiten Datenteil angibt.

9. Verfahren zum Betrieb eines Speichers (210, 212-1, . . ., 212-N), wobei das Verfahren Folgendes umfasst:
Verschieben von Daten, die in einem ersten Teil des Speichers beinhaltet sind und mit einer letzten logischen Blockadresse einer Anzahl logischer Blockadressen des ersten Teils des Speichers (210, 212-1, . . ., 212-N) verknüpft sind, zu einem physischen Block (107-0, 107-1, . . ., 107-B) des Speichers, der keine Daten darin gespeichert aufweist; und
Verschieben von Daten, die in einem zweiten Teil des Speichers beinhaltet sind und mit einer letzten logischen Blockadresse einer Anzahl logischer Blockadressen des zweiten Teils des Speichers (210, 212-1, . . ., 212-N) verknüpft sind, zu einem weiteren physischen Block (107-0, 107-1, . . ., 107-B) des Speichers, der keine Daten darin gespeichert aufweist,
wobei sich der physische Block (107-0, 107-1, . . ., 107-B) des Speichers (210, 212-1, . . ., 212-N), der keine Daten darin gespeichert aufweist, nach dem ersten Teil des Speichers und vor dem zweiten Teil des Speichers befindet;
wobei sich der weitere physische Block (107-0, 107-1, . . ., 107-B) des Speichers (210, 212-1, . . ., 212-N), der keine Daten darin gespeichert aufweist, nach dem zweiten Teil des Speichers (210, 212-1, . . ., 212-N) und vor dem ersten Teil des Speichers (210, 212-1, . . ., 212-N) befindet;
wobei sich der physische Block (107-0, 107-1, . . ., 107-B) des Speichers (210, 212-1, . . ., 212-N), der keine Daten darin gespeichert aufweist, und der weitere physische Block des Speichers (210, 212-1, . . ., 212-N), der keine Daten darin gespeichert aufweist, den ersten Teil des Speichers und den zweiten Teil des Speichers (210, 212-1, . . ., 212-N) trennen; und
wobei das Verfahren ferner Folgendes beinhaltet:
Verwenden algebraischer Zuordnung zwischen logischen und physischen Adressen, um eine Stelle im Speicher (210, 212-1, . . ., 212-N) des physischen Blocks (107-0, 107-1, . . ., 107-B) zu identifizieren, zu der die Daten im ersten Teil des Speichers (210, 212-1, . . ., 212-N) verschoben wurden; und
Verwenden algebraischer Zuordnung zwischen logischen und physischen Adressen, um eine Stelle im Speicher (210, 212-1, . . , 212-N) des weiteren physischen Blocks (107-0, 107-1, . . ., 107-B) zu identifizieren, zu der die Daten im zweiten Teil des Speichers (210, 212-1, . . ., 212-N) verschoben wurden.

10. Verfahren nach Anspruch 9, wobei das Verfahren Folgendes beinhaltet:
Verwenden der algebraischen Zuordnung zwischen logischen und physischen Adressen, um die Stelle im Speicher (210, 212-1, . . ., 212-N) des physischen Blocks (107-0, 107-1, . . ., 107-B) zu identifizieren, zu der die Daten im ersten Teil des Speichers (210, 212-1, . . ., 212-N) verschoben wurden, während einer Operation zum Erfassen dieser verschobenen Daten; und
Verwenden der algebraischen Zuordnung zwischen logischen und physischen Adressen, um die Stelle im Speicher (210, 212-1, . . ., 212-N) des weiteren physischen Blocks (107-0, 107-1, . . ., 107-B) zu identifizieren, zu der die Daten im zweiten Teil des Speichers (210, 212-1, . . ., 212-N) verschoben wurden, während einer Operation zum Erfassen dieser verschobenen Daten.

11. Verfahren nach Anspruch 9, wobei das Verfahren Verschieben der im ersten Teil des Speichers (210, 212-1, . . ., 212-N) beinhalteten Daten und Verschieben der im zweiten Teil des Speichers (210, 212-1, . . ., 212-N) beinhalteten Daten infolge eines Auslöseereignisses beinhaltet.

12. Verfahren nach Anspruch 11, wobei das Auslöseereignis eine bestimmte Anzahl von Programmoperationen, die auf dem Speicher (210, 212-1, . . ., 212-N) durchgeführt werden, oder ein Leistungszustandsübergang, der im Speicher (210, 212-1, . . ., 212-N) auftritt, ist.

13. Verfahren nach Anspruch 9, wobei;
Verschieben der im ersten Teil des Speichers (210, 212-1, . . ., 212-N) beinhalteten Daten zu dem physischen Block (107-0, 107-1, . . ., 107-B) des Speichers (210, 212-1, . . ., 212-N) darin resultiert, dass ein dritter physischer Block (107-0, 107-1, . . ., 107-B) des Speichers (210, 212-1, . . ., 212-N) keine Daten darin gespeichert aufweist; und
Verschieben der im zweiten Teil des Speichers (210, 212-1, . . ., 212-N) beinhalteten Daten zu dem weiteren physischen Block (107-0, 107-1, . . ., 107-B) des Speichers (210, 212-1, . . ., 212-N) darin resultiert, dass ein vierter physischer Block (107-0, 107-1, . . ., 107-B) des Speichers (210, 212-1, . . ., 212-N) keine Daten darin gespeichert aufweist; und
das Verfahren ferner Folgendes beinhaltet:
Verschieben von Daten, die im ersten Teil des Speichers (210, 212-1, . . ., 212-N) beinhaltet sind und mit einer unterschiedlichen der Anzahl von logischen Blockadressen des ersten Teils des Speichers (210, 212-1, . . ., 212-N) verknüpft sind, zu dem dritten physischen Block (107-0, 107-1, . . ., 107-B) des Speichers (210, 212-1, . . ., 212-N); und
Verschieben von Daten, die im zweiten Teil des Speichers (210, 212-1, . . ., 212-N) beinhaltet und mit einer unterschiedlichen der Anzahl von logischen Blockadressen des zweiten Teils des Speichers (210, 212-1, . . ., 212-N) verknüpft sind, zu dem vierten physischen Block (107-0, 107-1, . . ., 107-B) des Speichers (210, 212-1, . . ., 212-N).

## Revendications

1. Appareil (206), comprenant :
une mémoire (210, 212-1, . . ., 212-N) présentant une pluralité de blocs physiques (107-0, 107-1, . . ., 107-B) de cellules de mémoire, dans lequel :
la mémoire (210, 212-1, . . ., 212-N) inclut une première partie de données présentant un premier nombre d'adresses de blocs logiques associées, et une seconde partie de données présentant un second nombre d'adresses de blocs logiques associées ; et
deux de la pluralité de blocs physiques (107-0, 107-1, . . ., 107-B) de cellules de mémoire ne présentent aucune donnée stockée sur ceux-ci, dans lequel :
l'un des deux de la pluralité de blocs physiques (107-0, 107-1, . . ., 107-B) de cellules de mémoire qui ne présentent aucune donnée stockée sur ceux-ci est situé après la première partie de données et avant la seconde partie de données ;
l'autre des deux de la pluralité blocs physiques (107-0, 107-1, . . ., 107-B) de cellules mémoire qui ne présentent aucune donnée stockée sur ceux-ci est situé après la seconde partie de données et avant la première partie de données ;
les deux de la pluralité de blocs physiques (107-0, 107-1, . . ., 107-B) de cellules de mémoire qui ne présentent aucune donnée stockée sur ceux-ci séparent la première partie de données et la seconde partie de données dans la mémoire (210, 212-1, . . ., 212-N) ; et
des circuits (214, 314) configurés pour :
relocaliser les données de la première partie associée à la dernière adresse de bloc logique du premier nombre d'adresses de blocs logiques vers l'un des deux de la pluralité de blocs physiques (107-0, 107-1, . . ., 107-B) de cellules de mémoire qui ne présentent aucune donnée stockée sur ceux-ci ; et
relocaliser les données de la seconde partie associée à la dernière adresse de bloc logique du second nombre d'adresses de blocs logiques vers l'autre des deux de la pluralité de blocs physiques (107-0, 107-1, . . ., 107-B) de cellules de mémoire qui ne présentent aucune donnée stockée sur ceux-ci ;
utiliser une cartographie algébrique entre les adresses logiques et physiques pour identifier un emplacement dans la mémoire (210, 212-1, . . ., 212-N) de l'un des deux de la pluralité de blocs physiques (107-0, 107-1, . . ., 107-B) de cellules de mémoire vers lequel les données de la première partie ont été relocalisées ; et
utiliser une cartographie algébrique entre les adresses logiques et physiques pour identifier un emplacement dans la mémoire (210, 212-1, . . ., 212-N) de l'autre des deux de la pluralité de blocs physiques (107-0, 107-1, . . ., 107-B) de cellules de mémoire vers lequel les données de la seconde partie ont été relocalisées.

2. Appareil (206) selon la revendication 1, dans lequel :
la première partie des données comprend des données utilisateur ; et
la seconde partie des données comprend des données système.

3. Appareil (206) selon la revendication 1, dans lequel :
la première partie des données comprend les données qui ont été consultées à une fréquence ou à une fréquence supérieure à une fréquence particulière au cours des opérations de programme ou de détection effectuées sur la mémoire (210, 212-1, . . ., 212-N) ; et
la seconde partie des données comprend les données qui ont été consultées à une fréquence inférieure à une fréquence particulière au cours des opérations de programme ou de détection effectuées sur la mémoire (210, 212-1, . . ., 212-N).

4. Appareil (206) selon la revendication 1, dans lequel :
la première partie des données comprend des données de système d'exploitation ; et
la seconde partie des données comprend des données multimédia.

5. Appareil (206) selon la revendication 1, dans lequel la taille de chacune du premier nombre des adresses de bloc logiques est différente de la taille de chacune du second nombre des adresses de bloc logiques.

6. Appareil (206) selon la revendication 1, dans lequel le circuit est inclus dans la mémoire (210, 212-1, . . ., 212-N).

7. Appareil (206) selon la revendication 1, comprenant un dispositif de commande (208), dans lequel le circuit est inclus dans le dispositif de commande (208).

8. Appareil selon la revendication 1, dans lequel le circuit inclut :
un premier registre (320-1) configuré pour stocker une valeur indiquant une adresse de bloc physique pour les données de la première partie qui est associée à une première du premier nombre des adresses de bloc logiques ;
un deuxième registre (320-2) configuré pour stocker une valeur indiquant une adresse de bloc physique pour l'un des deux de la pluralité de blocs physiques (107-0, 107-1, . . ., 107-B) de cellules de mémoire qui ne présentent aucune donnée ;
un troisième registre (320-3) configuré pour stocker une valeur indiquant une adresse de bloc physique pour l'autre des deux de la pluralité de blocs physiques (107-0, 107-1, . . ., 107-B) de cellules de mémoire qui ne présentent aucune donnée ; et
un quatrième registre (320-4) configuré pour stocker une valeur indiquant une position relative d'une première du second nombre des adresses de bloc logique dans la seconde partie des données.

9. Procédé de fonctionnement d'une mémoire (210, 212-1, . . ., 212-N), le procédé comprenant :
la relocalisation des données incluses dans une première partie de la mémoire et associée à la dernière adresse de bloc logique d'un certain nombre d'adresses de blocs logiques de la première partie de la mémoire (210, 212-1, . . ., 212-N) vers un bloc physique (107-0, 107-1, . . ., 107-B) de la mémoire qui ne présente aucune donnée stockée sur celui-ci ; et
la relocalisation des données incluses dans une seconde partie de la mémoire et associée à la dernière adresse de bloc logique d'un certain nombre d'adresses de blocs logiques de la seconde partie de la mémoire (210, 212-1, . . ., 212-N) vers un autre bloc physique (107-0, 107-1, . . ., 107-B) de la mémoire qui ne présente aucune donnée stockée sur celui-ci,
dans lequel le bloc physique (107-0, 107-1, . . ., 107-B) de la mémoire (210, 212-1, . . ., 212-N) qui ne présente aucune donnée stockée sur celui-ci est situé après la première partie de la mémoire et avant la seconde partie de la mémoire ;
dans lequel l'autre bloc physique (107-0, 107-1, . . ., 107-B) de la mémoire (210, 212-1, . . ., 212-N) qui ne présente aucune donnée stockée sur celui-ci est situé après la seconde partie de la mémoire (210, 212-1, . . ., 212-N) et avant la première partie de la mémoire (210, 212-1, . . ., 212-N) ;
dans lequel le bloc physique (107-0, 107-1, . . ., 107-B) de la mémoire (210, 212-1, . . ., 212-N) qui ne présente aucune donnée stockée sur celui-ci et l'autre bloc physique de la mémoire (210, 212-1, . . ., 212-N) qui ne présente aucune donnée stockée sur celui-ci séparent la première partie de la mémoire et la seconde partie de la mémoire (210, 212-1, . . ., 212-N) ; et
dans lequel le procédé comprend en outre :
l'utilisation d'une cartographie algébrique entre les adresses logiques et physiques pour identifier un emplacement dans la mémoire (210, 212-1, . . ., 212-N) du bloc physique (107-0, 107-1, . . ., 107-B) vers lequel les données de la première partie de la mémoire (210, 212-1, . . ., 212-N) ont été relocalisées ; et
l'utilisation d'une cartographie algébrique entre les adresses logiques et physiques pour identifier un emplacement dans la mémoire (210, 212-1 212-N) de l'autre bloc physique (107-0, 107-1, . . ., 107-B) vers lequel les données de la seconde partie de la mémoire (210, 212-1, . . ., 212-N) ont été relocalisées.

10. Procédé selon la revendication 9, dans lequel le procédé inclut :
l'utilisation de la cartographie algébrique entre les adresses logiques et physiques pour identifier l'emplacement dans la mémoire (210, 212-1, . . ., 212-N) du bloc physique (107-0, 107-1, . . ., 107-B) vers lequel les données de la première partie de la mémoire (210, 212-1, . . ., 212-N) ont été relocalisées au cours d'une opération pour détecter ces données relocalisées ; et
l'utilisation de la cartographie algébrique entre les adresses logiques et physiques pour identifier l'emplacement dans la mémoire (210, 212-1, . . ., 212-N) de l'autre bloc physique (107-0, 107-1, . . ., 107-B) vers lequel les données de la seconde partie de la mémoire (210, 212-1, . . ., 212-N) ont été relocalisées au cours d'une opération pour détecter ces données relocalisées.

11. Procédé selon la revendication 9, dans lequel le procédé inclut la relocalisation des données incluses dans la première partie de la mémoire (210, 212-1, . . ., 212-N) et la relocalisation des données incluses dans la seconde partie de la mémoire (210, 212-1, . . ., 212-N) en réponse à un événement déclencheur.

12. Procédé selon la revendication 11, dans lequel l'événement déclencheur est un nombre particulier d'opérations de programme effectuées sur la mémoire (210, 212-1, . . ., 212-N) ou est une transition d'état d'alimentation se produisant dans la mémoire (210, 212-1, . . ., 212-N).

13. Procédé selon la revendication 9, dans lequel ;
la relocalisation des données incluses dans la première partie de la mémoire (210, 212-1, . . ., 212-N) vers le bloc physique (107-0, 107-1, . . ., 107-B) de la mémoire (210, 212-1, . . ., 212-N) a pour résultat qu'un troisième bloc physique (107-0, 107-1, . . ., 107-B) de la mémoire (210, 212-1, . . ., 212-N) ne présente aucune donnée stockée sur celui-ci ; et
la relocalisation des données incluses dans la seconde partie de la mémoire (210, 212-1, . . ., 212-N) vers l'autre bloc physique (107-0, 107-1, . . ., 107-B) de la mémoire (210, 212-1, . . ., 212-N) a pour résultat qu'un quatrième bloc physique (107-0, 107-1, . . ., 107-B) de la mémoire (210, 212-1, . . ., 212-N) ne présente aucune donnée stockée sur celui-ci ; et
le procédé inclut en outre :
la relocalisation des données incluses dans la première partie de la mémoire (210, 212-1, . . ., 212-N) et associées à une adresse différente du nombre d'adresses de bloc logique de la première partie de la mémoire (210, 212-1, . . ., 212-N) vers le troisième bloc physique (107-0, 107-1, . . ., 107-B) de la mémoire (210, 212-1, . . ., 212-N) ; et
la relocalisation des données incluses dans la seconde partie de la mémoire (210, 212-1, . . ., 212-N) et associées à une adresse différente du nombre d'adresses de bloc logique de la seconde partie de la mémoire (210, 212-1, . . ., 212-N) vers le quatrième bloc physique (107-0, 107-1, . . ., 107-B) de la mémoire (210, 212-1, . . ., 212-N).
